# EUROPEAN PATENT SPECIFICATION

(11) **EP 2 463 173 B1**
(45) Date of publication and mention of the grant of the patent: **12.02.2020**
(21) Application number: 10838375.3
(22) Date of filing: 03.06.2010
(51) Int. Cl.: B61D 17/04, A62C 3/00, G06N 5/00

(54) **METHOD FOR IMPROVING VEHICLE BODY FIREPROOF PERFORMANCE**
VERFAHREN ZUR ERHÖHUNG DER FEUERSCHUTZLEISTUNG EINER FAHRZEUGKAROSSERIE
PROCÉDÉ D'AMÉLIORATION DES PERFORMANCES PARE-FEU D'UNE CARROSSERIE DE VÉHICULE

(30) Priority: 31.05.2010 CN 201010187271
(43) Date of publication of application: 13.06.2012
(73) Proprietor: CRRC Tangshan Co., Ltd., Fengrun Tangshan, Hebei 063035 (CN)
(72) Inventor: SUN, Bangcheng, Tangshan Hebei 063035 (CN); ZHANG, Guoping, Tangshan Hebei 063035 (CN); ZHANG, Lirong, Tangshan Hebei 063035 (CN)
(74) Representative: Pfenning, Meinig & Partner mbB
(86) International application number: PCT/CN2010/073523
(87) International publication number: WO 2011/150568

(56) References cited:
- CN-C- 1 213 100
- DE-A1- 10 155 820
- GB-A- 666 169
- US-A1- 2009 126 600
- GUO,SHENGRUI ET AL.: 'Brief Introduction of Fireproof Technology for French Vehicle.' FOREIGN ROLLING STOCK. vol. 21, no. 3, June 1989, pages 1 - 5, XP008148321
- DAI,CHANGGANG ET AL.: 'Study on Railway Vehicle Fireproofing Standards in China.' URBAN MASS TRANSIT. vol. 21, no. 5, May 2008, pages 1 - 4, XP008148247

## Description

### FIELD OF THE TECHNOLOGY

The present invention relates to a fireproofing technology of a high-speed vehicle body, and particularly to a method for improving the fireproofing performance of a vehicle body.

### BACKGROUND OF THE TECHNOLOGY

The fireproofing technology requirements for railway vehicles, motor train unit or metro products, such as TB/T3138-2006 Technical specification of flame retardant materials for rolling stock and the Regulations of the International Union of Railways of the UIC564-2 and UIC642, define the flame retardant property of non-metal materials, i.e. the method of measuring oxygen index of 45° combustion, which is used to mainly measure oxygen index, flame retardation and smoke density. However, the requirements for fireproofing performance cannot yet be satisfied only based on these three indexes, in particular there is not any feasible basis for the fireproofing performance of a metal vehicle body, that is to say, in prior art, in case an unexpected fire risk is caused by non-metal materials in the vehicle body and a big fire is aroused instantaneously, the entire carriage or train will be burnt, which result to softening, deformation and collapse of the metal vehicle body and further affect the personnel evacuation and rescue operation. Therefore, the vehicle is lack of travelling capacity at safe speed. It has been known from GB-A-666,169 to determine potential burning damage areas in a vehicle body and to provide detectors in these areas to detect deformations due to high temperature. In case of deformation, a safety equipment is brought into operation.

XP008148321A discloses a method which teaches that calculation of a vehicle body should be carried out with regard to strength and rigidity under a predetermined high temperature, not under normal conditions.

On the whole, owing to higher requirements of high-speed trains (and vehicles) for the safety performance and reliability as well as their vulnerability to external and internal ambient factors, a feasible, preventive fireproofing measure and method for improving the fireproofing performance of metal vehicles shall be provided by the skilled person in prior art, so as to ensure safe driving and prevent occurrence of accidental fire risk.

### SUMMARY

The technical solution of the present invention is to provide a method for improving the fireproofing performance of a vehicle body to resolve the problems of prior art that in the event of insufficient strength of the vehicle body under heat-load conditions, the preventive fireproofing measure is able to retard the expansion of fire risk to avoid the overburning of the entire vehicle within very short time, casualty and property loss arising from failure of evacuation in the case of the fire risk caused by non-metal materials and electric parts in the vehicles.

In order to solve the above problem, the present invention discloses a method for improving the fireproofing performance of a vehicle body, which includes the steps of claim 1.

As a preferred option, the said method further includes the following steps executed repeatedly: if the fireproofing treatment has been performed, reassuming a predetermined high temperature load is exerted on the potential burning damage area and calculating deformation amount of the vehicle body according to the situation of fireproofing treatment; and

on the basis of the deformation amount of the vehicle body, judging whether a space between a underbody suspension parts and rail surface satisfies the traveling capability requirements at a safe speed after the deformation of the vehicle body; if not, performing fireproofing treatment on the burning damage area of the vehicle body and then returning to the step of calculating deformation amount of the vehicle body, and if yes, finishing the process.

As a preferred option, the manner of the performing fireproofing treatment to the potential burning damage area of the vehicle body comprises: sticking non-metal fireproof material of heat expansion onto the potential burning damage area of the vehicle body.

As a preferred option, the said method also includes brushing a layer of moistureproof paint onto the non-metal fireproof material of heat expansion.

As a preferred option, a range of predetermined high temperature is between 700° and 950°.

As a preferred option, the vehicle body comprises the body of urban railway, subway, motor train unit, rolling stock and magnetic suspension.

As a preferred option, the potential burning damage area of the vehicle body is defined by considering at least one of following factors: strength weak area of the vehicle body, assuming initiation position, inflammable area.

As a preferred option, the manner of the considering manner is: obtaining more likely initiation position as the assuming initiation position according to statistic data;determining the inflammable area according to the factors of used material and so on; and calculating to obtain the potential burning damage area by using 3D model of the vehicle body and the strength weak area of the vehicle body.

As a preferred option, the step of the calculating deformation amount of the vehicle body given that a predetermined high temperature load is exerted on the potential burning damage area is performed by using the manner of finite element.

As compared with prior art, the present invention has the following advantages:

With little cost of calculation and non-metal materials, the present invention could improve heat-load strength performance of the metal vehicle body, thus reducing the fire risk and satisfying the requirement of travelling capacity; in the case of any fire risk, it's possible to win more time for evacuation and rescue, so as to guarantee the personnel safety and minimize the loss of properties.

### BRIEF DESCRIPTION OF THE DRAWINGS

FIG. 1 is a flow process chart of an embodiment of the present invention of the method for improving the fireproofing performance of vehicle body;
FIG. 2 is a schematic view of a damage model of middle vehicles of the present invention;
FIG. 3-a is a curve graph of the relationship between aluminum alloy vehicle body's E-elastic modulus and temperature in the present invention;

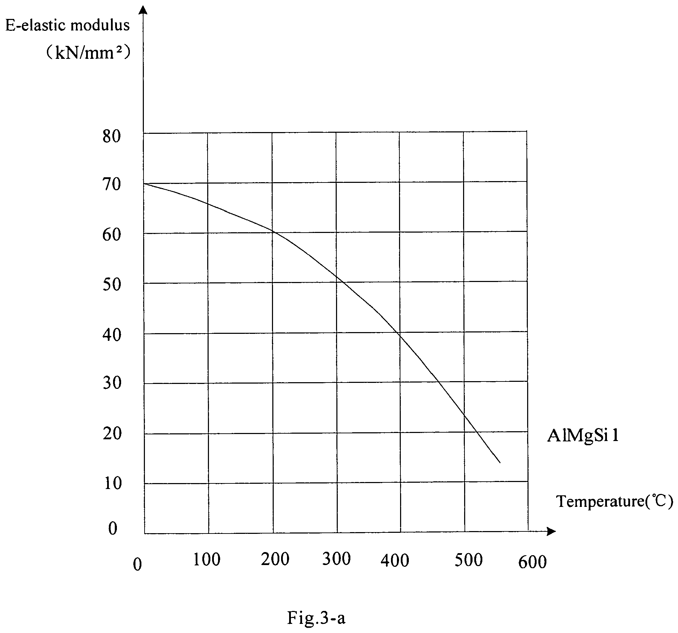

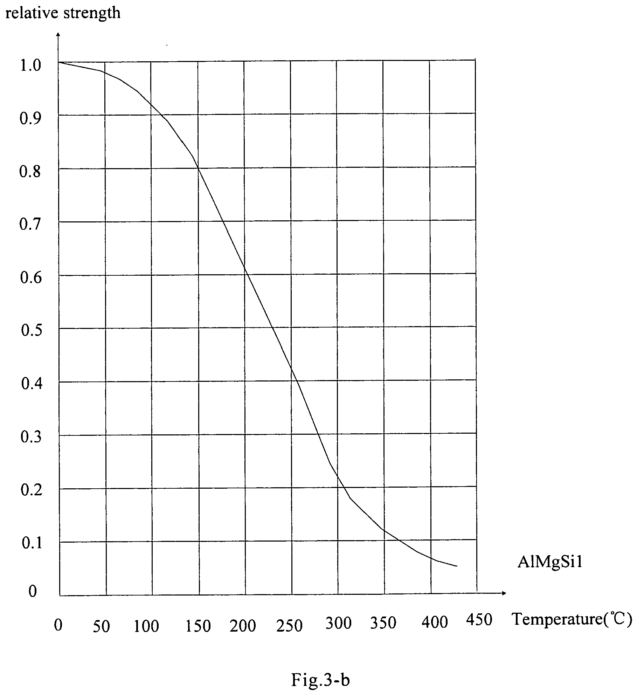

FIG. 3-b is a curve graph of the relationship between aluminum alloy vehicle body's relative strength and temperature in the present invention.

### DETAILED DESCRIPTION OF THE PREFERRED EMBODIMENTS

In order to make the objects, technical solutions and merits of the present invention clearer, a further detailed description of embodiments of the present invention is given by reference to accompanying drawings
One of the core concept of the present invention is that: assuming the temperature of fire reach 700° ∼ 950°, the heat-load deformation of weakest point of static strength of the vehicle body is calculated to verify whether the softening, deformation and collapse of vehicle body arising from loss of strength and stiffness affect the implementation of evacuation, escape and rescue or not, and whether reliable travelling capacity within a certain period of time is available at safe speed or not. After calculation and verification, if the vehicle body does not satisfy the requirement of fireproofing performance, i.e. travelling capacity, non-metal fireproof materials of heat expansion are attached to the weakest area of static strength of the vehicle body, so as to restrain the vehicle deformation arising from sharp temperature rise of the fire. Through calculation and verification, the vehicle body design can be modified several times until the fireproofing performance is satisfied.

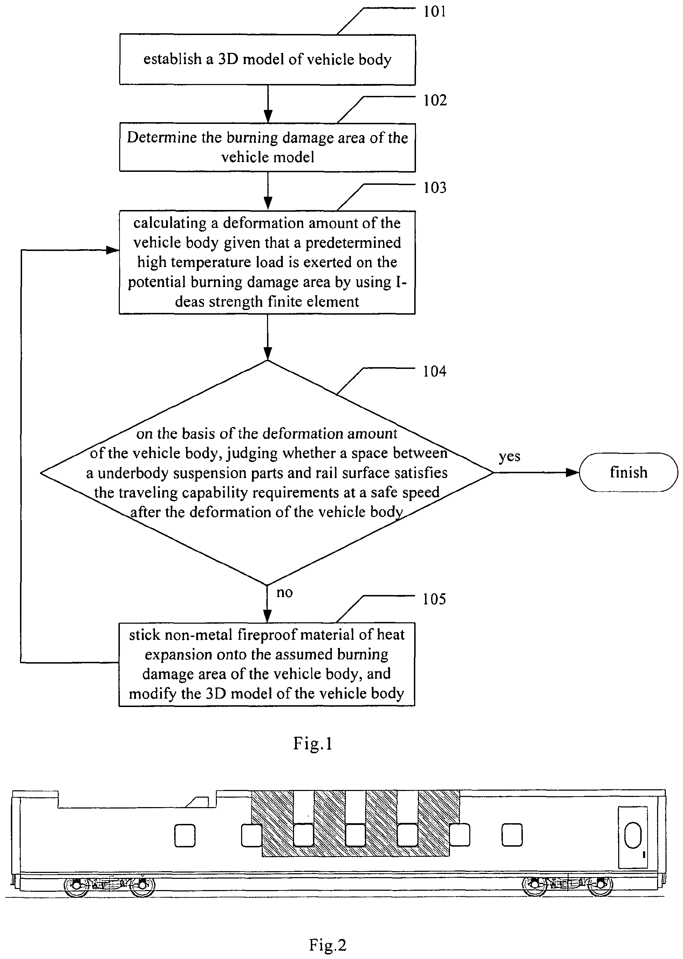

FIG. 1 illustrates a flow process chart of an embodiment of the present invention of the method for improving the fireproofing performance of vehicle body, which includes the following steps:
Step 101: establish a 3D model of vehicle body;
Step 102: assume the burning area of fire;

When the fire is fully developed, the ceiling temperature could reach 700° ∼ 950°, the strength of material depends on temperature, and metal vehicle body will be gradually lost the strength with the temperature rise. In this preferred embodiment, three middle windows are assumed as burning areas (i.e.: weak area of strength), and the 3D model of vehicle body is shown in FIG. 2, wherein the shadows represent the burning areas.

Step 103: analyze the vehicle deformation by using I-deas strength finite element;

Step 104: use the calculated deformation to verify whether the space between the underbody suspension parts and rail surface satisfies the traveling capability requirements at a safe speed; if yes, finish the process; otherwise, proceed Step 105;

Step 105: stick non-metal fireproof material of heat expansion onto the assumed burning damage area of the vehicle body, and modify the 3D model of the vehicle body; repeat Step 103 until satisfying the predetermined performance requirements.

In another preferred embodiment of the present invention, a layer of moistureproof paint is further brush after sticking non-metal fireproof material of heat expansion onto the area requiring reinforcement.

The following is a description based on aluminum alloy vehicle body:

The vehicle body is made of AlMgSi1-aluminum alloy, with the relationship between the temperature and relative strength shown in FIGS. 3-a and 3-b. It can be seen that, the relationship between AlMgSi 1 aluminum alloy E-elastic modulus and temperature is significant; the strength of aluminum alloy will decline with temperature rise; the calculating parameters of the vehicle model can be determined according to the curve:
(1) When the temperature is higher than 300°, aluminum alloy's elastic modulus drops abruptly, and the relative strength declines to zero;
(2) When the temperature ranges between 200° and 300°, aluminum alloy's elastic modulus drops quickly, and the relative strength declines abruptly, with the strength taken in the case of 300°;
(3) When the temperature ranges between 100° and 200°, aluminum alloy's elastic modulus drops slowly, and the relative strength declines quickly, with the strength taken in the case of 200°;
(4) When the temperature is lower than 100°, aluminum alloy's elastic modulus and relative strength are in normal range.

In the strength design of the vehicle body available with travelling capacity in the case of big fire, only rupture strength is considered, rather than fatigue strength generally.

FIG. 2 illustrates a damage model of middle vehicles of the present invention, wherein it's assumed that the fire from the central hall of the carriage is spread to the width of 3 windows. The worst situation is at the bending moment along the length of the vehicle body, the weakest area begins from the window's lower edge and two lateral flanges to the next middle window, so the strength at 250mm of the window's lower edge, both sides of enter door and top area of the entrance is weak.

After calculation of the weak area of strength, a layer of moistureproof paint is brushed after sticking non-metal fireproof material of heat expansion onto the area requiring reinforcement. Then, it's required to calculate again whether the traveling capability requirements is satisfied, so as to ensure that motor train unit has a travelling capacity at 40km/h for 15 minutes in fire (fully developed).

It's worthy to note that, the aforesaid preferred embodiments are described based on locomotives, but the present invention can also be applied to another vehicle, such as urban railway, subway, motor train unit, rolling stock and magnetic suspension.

For the purpose of description, the aforesaid preferred embodiments of the said method are represented as a combination of a series of operations, but it's well understood by those skilled person in the art that the present invention isn't restricted by the described operation sequence, since some steps can be implemented by other sequence or simultaneously according to the present invention. Also, it's understood that the aforesaid preferred embodiments of the said method belong to preferred options, so the associated operations and modules are not necessarily covered by the present invention.

The preferred embodiments herein are described in a progressive way, and the highlights of every preferred embodiment may differ from each other, so the equivalent or similar parts of every preferred embodiment may be referenced.

The above is a detailed description of improving the fireproofing performance of vehicles. It should be noted that the above embodiments are merely provided for describing the technical solutions of the present invention. The above embodiments is intended for providing a understanding of the method and core concept of the present invention; it should be appreciated that the present invention is capable of a variety of embodiments and various modifications by those skilled in the art, provided that they are covered by claim 1 and claims depending thereon.

## Claims

1. A method for improving the fireproofing performance of a potential burning damage area of a vehicle body by simulating calculation, **characterized by** the steps of :
determining the potential burning damage area of the vehicle body;
calculating a deformation amount of the vehicle body given that a predetermined high temperature load is exerted on the potential burning damage area; and
on the basis of the deformation amount of the vehicle body, judging whether a space between a underbody suspension parts and rail surface satisfies traveling capability requirements at a safe speed after the deformation of the vehicle body; if not, performing fireproofing treatment on the potential burning damage area of the vehicle body, the manner of the performing fireproofing treatment to the potential burning damage area of the vehicle body comprises: sticking non-metal fireproof material of heat expansion onto the potential burning damage area of the vehicle body to restrain the deformation of the vehicle body arising from temperature rise of a fire, and the travelling capability requirements at a safe speed is to travel at a speed of 40km/h for 15 minutes.

2. The method according to the claim 1, **characterized in that** it further comprises the following steps executed repeatedly:
if the fireproofing treatment has been performed, reassuming a predetermined high temperature load exerted on the potential burning damage area and calculating deformation amount of the vehicle body according to the situation of fireproofing treatment; and
on the basis of the deformation amount of the vehicle body, judging whether a space between a underbody suspension parts and rail surface satisfies the traveling capability requirements at a safe speed after the deformation of the vehicle body; if not, performing fireproofing treatment on the burning damage area of the vehicle body and then returning to the step of calculating deformation amount of the vehicle body, and if yes, finishing the process.

3. The method according to the claim 1, **characterized in that** it further comprises: brushing a layer of moistureproof paint onto the non-metal fireproof material of heat expansion.

4. The method according to the claim 1, **characterized in that** a range of predetermined high temperature is between 700° and 950°.

5. The method according to the claim 1, **characterized in that** the vehicle body comprises the body of urban railway, subway, motor train unit, rolling stock and magnetic suspension.

6. The method according to the claim 1, **characterized in that** the potential burning damage area of the vehicle body is defined by considering at least one of following factors:
strength weak area of the vehicle body, assuming initiation position, inflammable area.

7. The method according to the claim 6, **characterized in that** a manner of the considering is:
obtaining more likely initiation position as the assuming initiation position according to statistic data;
determining the inflammable area according to factors of used materials and so on; and
calculating to obtain the potential burning damage area by using 3D model of the vehicle body and the strength weak area of the vehicle body.

8. The method according to the claim 1, **characterized in that** the step of the calculating deformation amount of the vehicle body given that a predetermined high temperature load is exerted on the potential burning damage area is performed by using the manner of finite element.

## Patentansprüche

1. Verfahren zum Verbessern der Brandschutzleistung eines potenziellen Brandschadenbereichs einer Fahrzeugkarosserie durch Simulationsberechnung, **gekennzeichnet durch** die Schritte des:
Bestimmens des potentiellen Brandschadenbereichs der Fahrzeugkarosserie;
Berechnens eines Verformungsumfangs der Fahrzeugkarosserie, unter der Vorrausetzung, dass eine vorherbestimmte Hochtemperaturlast auf den potenziellen Brandschadenbereich ausgeübt wird; und
auf der Grundlage des Verformungsumfangs der Fahrzeugkarosserie, Beurteilens, ob ein Raum zwischen einer Unterboden-Aufhängungsteile- und-Schienen-Oberfläche die Fahrfähigkeitsanforderungen mit einer sicheren Geschwindigkeit nach der Verformung der Fahrzeugkarosserie erfüllt; falls nicht, Durchführens einer Brandschutzbehandlung auf den potenziellen Brandschadenbereich der Fahrzeugkarosserie, wobei die Art und Weise des Durchführens einer Brandschutzbehandlung auf den potenziellen Brandschadenbereich der Fahrzeugkarosserie umfasst: Aufkleben eines nicht-metallischem Brandschutzmaterials mit Wärmeausdehnung auf den potenziellen Brandschadenbereich der Fahrzeugkarosserie, um die Verformung der Fahrzeugkarosserie infolge des Temperaturanstiegs durch einen Brand zu begrenzen, und die Fahrfähigkeitsanforderungen mit einer sicheren Geschwindigkeit Fahren mit einer Geschwindigkeit von 40 km/h für 15 Minuten sind.

2. Verfahren nach Anspruch 1, **dadurch gekennzeichnet, dass** es ferner die folgenden wiederholt ausgeführten Schritte umfasst:
falls die Brandschutzbehandlung durchgeführt wurde, erneutes Annehmen einer vorherbestimmten Hochtemperaturlast, die auf den potenziellen Brandschadenbereich ausgeübt wird, und Berechnen des Verformungsumfangs der Fahrzeugkarosserie entsprechend der Situation der Brandschutzbehandlung; und
auf der Grundlage des Verformungsumfangs der Fahrzeugkarosserie, Beurteilen, ob ein Raum zwischen einer Unterboden-Aufhängungsteile- und-Schienen-Oberfläche die Fahrfähigkeitsanforderungen mit einer sicheren Geschwindigkeit nach der Verformung der Fahrzeugkarosserie erfüllt; falls nicht, Durchführen einer Brandschutzbehandlung auf den Brandschadenbereich der Fahrzeugkarosserie und dann Zurückkehren zum Schritt des Berechnens des Verformungsumfangs der Fahrzeugkarosserie, und falls ja, Beenden des Prozesses.

3. Verfahren nach Anspruch 1, **dadurch gekennzeichnet, dass** es ferner umfasst: Aufbürsten einer Schicht aus feuchtigkeitsbeständiger Farbe auf das nicht-metallische Brandschutzmaterial mit Wärmeausdehnung.

4. Verfahren nach Anspruch 1, **dadurch gekennzeichnet, dass** ein Bereich einer vorherbestimmten hohen Temperatur zwischen 700° und 950° liegt.

5. Verfahren nach Anspruch 1, **dadurch gekennzeichnet, dass** die Fahrzeugkarosserie die Karosserie einer S-Bahn, U-Bahn, eines Triebzugs, Schienenfahrzeugs und einer Magnetschwebebahn umfasst.

6. Verfahren nach Anspruch 1, **dadurch gekennzeichnet, dass** der potenzielle Brandschadenbereich der Fahrzeugkarosserie durch Berücksichtigen zumindest eines der folgenden Faktoren definiert wird:
Festigkeitsschwächebereich der Fahrzeugkarosserie, angenommene Initiationsposition, brennbarer Bereich.

7. Verfahren nach Anspruch 6, **dadurch gekennzeichnet, dass** eine Art und Weise des Berücksichtigens ist: Erhalten einer wahrscheinlicheren Initiationsposition als die angenommene Initiationsposition gemäß statistischen Daten;
Bestimmen des brennbaren Bereichs gemäß Faktoren der verwendeten Materialien und so weiter; und
Berechnen, um den potenziellen Brandschadenbereich zu erhalten, unter Verwendung eines 3D-Modells der Fahrzeugkarosserie und des Festigkeitsschwächebereichs der Fahrzeugkarosserie.

8. Verfahren nach Anspruch 1, **dadurch gekennzeichnet, dass** der Schritt des Berechnens des Verformungsumfangs der Fahrzeugkarosserie unter der Voraussetzung, dass eine vorherbestimmte Hochtemperaturlast auf den potenziellen Brandschadenbereich ausgeübt wird, unter Verwendung der Methode des finiten Elements durchgeführt wird.

## Revendications

1. Procédé destiné à améliorer les performances d'ignifugation d'une zone potentielle d'endommagement dû au feu d'une caisse de véhicule par un calcul de simulation, **caractérisé par** les étapes suivantes :
déterminer la zone potentielle d'endommagement dû au feu de la caisse du véhicule ;
calculer une quantité de déformation de la caisse du véhicule étant donné qu'une charge à haute température prédéterminée est exercée sur la zone potentielle d'endommagement dû au feu ; et
sur la base de la quantité de déformation de la caisse du véhicule, juger si un espace entre les parties suspension sous la caisse et la surface du rail, satisfait à des exigences de capacité de déplacement à une vitesse sûre après la déformation de la caisse du véhicule ; sinon, exécuter un traitement d'ignifugation sur la zone potentielle d'endommagement dû au feu de la caisse du véhicule, la façon d'exécuter le traitement d'ignifugation sur la zone potentielle de dommages dû au feu de la caisse du véhicule comprend l'étape suivante : coller un matériau ignifuge métallique d'expansion de la chaleur sur la zone potentielle de dommages dû au feu de la caisse du véhicule pour contenir la déformation de la caisse du véhicule survenant en raison de l'élévation de la température d'un feu, et les exigences de capacité de déplacement à une vitesse sûre, sont de se déplacer à une vitesse égale à 40 km/h pendant 15 minutes.

2. Procédé selon la revendication 1, **caractérisé en ce qu'**il comprend en outre les étapes suivantes exécutées à plusieurs reprises :
si le traitement d'ignifugation a été exécuté, reprendre une charge à haute température prédéterminée exercée sur la zone d'endommagement dû au feu, et calculer la quantité de déformation de la caisse du véhicule selon la situation du traitement d'ignifugation ; et
sur la base de la quantité de déformation de la caisse du véhicule, juger si un espace entre les parties suspension sous la caisse et la surface du rail, satisfait aux exigences de capacité de déplacement à une vitesse sûre après la déformation de la caisse du véhicule ; sinon, exécuter un traitement d'ignifugation sur la zone d'endommagement dû au feu de la caisse du véhicule, et revenir ensuite à l'étape de calcul de la quantité de déformation de la caisse du véhicule, et si oui, terminer le processus.

3. Procédé selon la revendication 1, **caractérisé en ce qu'**il comprend en outre l'étape suivante : brosser une couche de peinture étanche à l'humidité sur le matériau d'expansion thermique ignifuge non métallique.

4. Procédé selon la revendication 1, **caractérisé en ce que** la plage de températures élevées prédéterminée est comprise entre 700 °C et 950 °C.

5. Procédé selon la revendication 1, **caractérisé en ce que** la caisse du véhicule comprend la caisse d'un chemin de fer urbain, d'un métro, d'une unité de train motorisée, d'un matériel roulant et d'une suspension magnétique.

6. Procédé selon la revendication 1, **caractérisé en ce que** la zone d'endommagement dû au feu de la caisse du véhicule, est définie en prenant en considération l'un au moins des facteurs suivants : zone de faiblesse de la résistance de la caisse du véhicule, position de déclenchement supposée, zone inflammable.

7. Procédé selon la revendication 6, **caractérisé en ce qu'**une façon de prendre en considération consiste à :
obtenir une position de déclenchement plus probable en tant que position de déclenchement supposée selon des données statistiques ;
déterminer la zone inflammable selon les facteurs des matériaux utilisés et ainsi de suite ; et
calculer de façon à obtenir la zone d'endommagement dû au feu à l'aide d'un modèle 3D de la caisse du véhicule, et de la zone de faiblesse de la résistance de la caisse du véhicule.

8. Procédé selon la revendication 1, **caractérisé en ce que** l'étape de calcul de la quantité de déformation de la caisse du véhicule étant donné qu'une charge à température élevée prédéterminée est exercée sur la zone d'endommagement dû au feu, est exécutée à l'aide d'éléments finis.
